Europäisches Patentamt

European Patent Office

Office européen des brevets

(19)

(11) Publication number: **0 087 764**
**B1**

(12) **EUROPEAN PATENT SPECIFICATION**

(45) Date of publication of patent specification: **06.08.86**

(21) Application number: **83101807.2**

(22) Date of filing: **24.02.83**

(51) Int. Cl.⁴: **H 03 K 3/38**

(54) Josephson pulse generator of current injection type.

(30) Priority: **26.02.82 JP 30316/82**
**26.02.82 JP 30317/82**

(43) Date of publication of application:
**07.09.83 Bulletin 83/36**

(45) Publication of the grant of the patent:
**06.08.86 Bulletin 86/32**

(84) Designated Contracting States:
**DE FR GB IT NL**

(56) References cited:
EP-A-0 074 666
GB-A-2 078 046
US-A-4 275 314

IBM TECHNICAL DISCLOSURE BULLETIN, vol.
25, no. 3A, August 1982 S.M. FARIS et al.
"Isolator for Josephson Logic", pages 1207-
1208

IBM TECHNICAL DISCLOSURE BULLETIN, vol.
22, no. 2, July 1979 S.M. FARIS et al. "Pulsed
output star driver", pages 846-847

(73) Proprietor: **NEC CORPORATION**
**33-1, Shiba 5-chome, Minato-ku**
**Tokyo 108 (JP)**

(72) Inventor: **Tahara, Shuichi**
**Nippon Electric Co., Ltd. 33-1, Shiba Gochome**
**Minato-ku Tokyo (JP)**
Inventor: **Sone, Junichi**
**Nippon Electric Co., Ltd. 33-1, Shiba Gochome**
**Minato-ku Tokyo (JP)**

(74) Representative: **Moll, Walter, Dipl.-Phys., Dr.**
**et al**
**Patentanwälte Glawe, Delfs, Moll & Partner**
**Liebherrstrasse 20 Postfach 162**
**D-8000 München 26 (DE)**

(56) References cited:
IEEE TRANSACTIONS ON ELECTRON
DEVICES, vol. ED-27, no. 10, October 1980 T.R.
GHEEWALA "Josephson-logic devices and
circuits", pages 1857-1869

APPLIED PHYSICS LETTERS, vol. 36, no. 12,
June 1980, New York D.B. TUCKERMAN "A
Josephson ultrahigh-resolution sampling
system", pages 1008-1010

Courier Press, Leamington Spa, England.

## Description

The present invention relates to a circuit utilizing Josephson junctions of the type having first and second ends and having an extremely low impedance between said first and second ends in a zero voltage state and a high impedance between said first and second ends in a voltage state and changing from said zero voltage state to said voltage state in response to a current flowing between said first and second ends which is greater than a respective critical current, comprising a first group of "N" (N≧2) resistors connected together at one end thereof and each having a predetermined resistance, a second group of "N−1" resistors each being connected between the other ends of two of said "N"-resistors and having a predetermined resistance, said second group of resistors being connected in series between a first node and a second node, a first group of "N" Josephson junctions connected between a reference potential and respective ones of said other ends of said first group of resistors and each having a predetermined critical current.

To realize a high-speed computer with low power consumption using the Josephson junction integrated circuit, not only must the memory circuit, logic circuit and control circuit making up the computer operate with a short access time or cycle time but also the pulse rise time and pulse fall time as well as the pulse width must be short.

In order to satisfy this requirement a circuit utilizing Josephson junctions has been proposed in GB—A—20 78 046, which corresponds to the above mentioned kind.

From EP—A2—0074666 published on 23.03.83 a logic gate circuit utilizing the Josephson effect is known which has very short gate delay time and a wide operational margin and a is feasible for a high degree of integration. This known circuit comprises a group of N of parallel branches, each branch consisting of a series connection of a resistor and a Josephson junction, connected in parallel, a chain of series connected N−1 resistors each connecting the junction points of resistor and Josephson junction of two adjacent branches, and a further Josephson junction connecting an input terminal with one end of said chain of resistors. Each resistor and each Josephson junction of the known circuit has a predetermined resistance and critical current, respectively. This older European patent application falls under Article 54, paragraph 3 of the EPC.

It is an object of the present invention to provide a Josephson pulse generator of current injection type of the known kind which has an improved operation margin and gain and is capable of generating pulses of very short pulse width.

This object according to the invention is solved by the features that the circuit further comprises first Josephson junction connected at one end thereof with said first node and having a predetermined critical current, a first resistor connected between said reference potential and the other end of said first Josephson junction and having a predetermined resistance, a second Josephson junction connected at one end thereof with said second node and having a predetermined critical current, and a second resistor connected with the other end of said second Josephson junction and having a predetermined resistance.

In a preferred embodiment the circuit further comprises an inductance component connected in series with said first resistor and having a predetermined inductance value. Preferably the number of Josephson junctions and first resistors is two of three.

Preferably the Josephson pulse generator according to the invention satisfies the conditions described in claims 6 and 7, respectively.

Other objects and features of the present invention will become apparent from the following description referring to the accompanying drawings.

Brief description of the drawings

Figure 1 is a circuitry of a pulse generator representing one embodiment of the present invention;

Figure 2 is a diagram showing an output pulse waveform from the circuit of Figure 1;

Figure 3 is a control characteristic diagram for the gate circuit of the pulse generator of Figure 1;

Figure 4 is an improved circuitry of a pulse generator according to another embodiment of the present invention; and

Figures 5 and 6 are circuitry of pulse generators according to further embodiments of the present invention.

Detailed description of the preferred embodiments

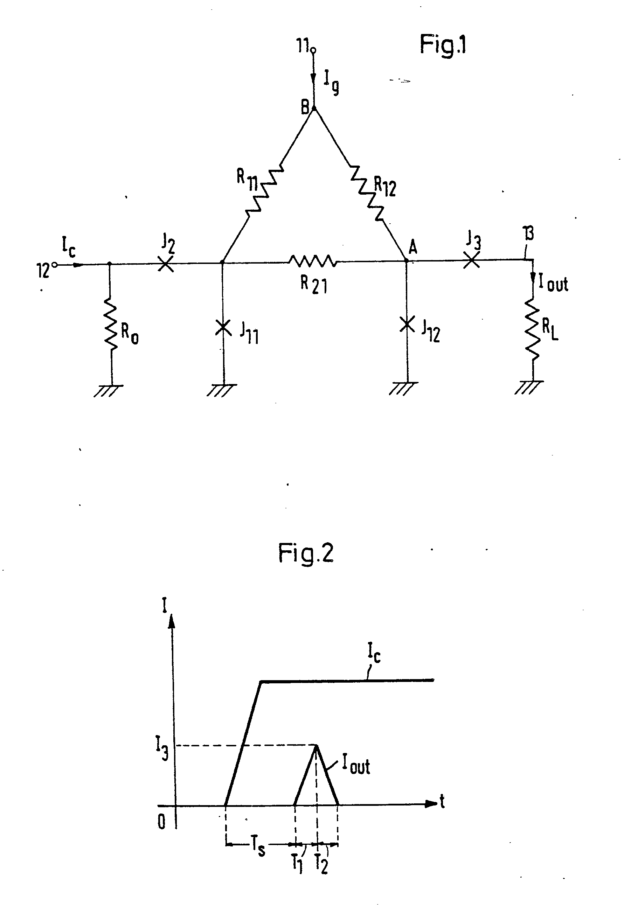

Figure 1 shows a pulse generator of current injection type according to a first embodiment of this invention. In this figure, reference symbols $J_{11}$, $J_{12}$, $J_2$ and $J_3$ denote Josephson junctions having critical currents $I_{11}$, $I_{12}$, $I_2$ and $I_3$ respectively; $R_{11}$, $R_{12}$, $R_{21}$, $R_0$ resistors having resistances $r_{11}$, $r_{12}$, $r_{21}$ and $r_0$ respectively; 11 a gate current supply terminal; 12 an input terminal; 13 an output line; and $R_L$ a load resistor with a resistance $r_L$. With the pulse generator of this embodiment, an input/output separation function is added to the pulse generation function and an improvement is made on the gain.

The gate current $I_g$ supplied from the gate current supply terminal 11 is divided into two paths, a first path consisting of the resistor $R_{11}$ and the Josephson junction $J_{11}$ and a second path consisting of the resistor $R_{12}$ and the Josephson junction $J_{12}$. With currents $I_{g1}$ and $I_{g2}$ flowing through the first path and second path, respectively ($I_{g1}+I_{g2}=I_g$), the input current Ic injected from the input terminal 12 flows through the Josephson junctions $J_2$ and $J_{11}$ into ground. Consequently, into the Josephson junction $J_{11}$, both the gate current $I_{g1}$ and the input current Ic are injected to switch the junction $J_{11}$ into the voltage state. The current flowing through the Josephson junction $J_{11}$ is then injected into the Josephson junction $J_{12}$ through the resistor $R_{21}$ and the resistors $R_{11}$, $R_{12}$ thereby switching the Josephson junction $J_{12}$ into the voltage state. Accordingly, the gate current $I_g$ is distributed into two paths, a first path consisting of the Josephson junction $J_2$ and the resistor $R_0$ and a second path consisting of the Josephson junction $J_3$, an output line 13 and the load resistor $R_L$. If $r_L$ is set greater than $r_0$, almost all the gate current $Ig$ flows into the first path, switching the Josephson junction $J_2$ into the voltage state. As a result, the input current $Ic$ flows through the resistor $R_0$ into ground while the gate current $I_g$ flows through the Josephson $J_3$, the output line 13 and into the load resistor $R_L$, thereby achieving the separation between the input and output.

When the current flowing through the output line 13 exceeds the critical current value $I_3$ of the Josephson junction $J_3$, the Josephson junction $J_3$ is switched into the voltage state, interrupting the output current. Therefore, a pulse current is obtained through the output line 13. The gate current $I_g$ is distributed according to the resistance values of the four Josephson junctions in the voltage state and flows into ground.

Figure 2 shows an waveform of the output pulse current $I_{out}$ obtained in a manner described above. The pulse current $I_{out}$ starts to rise after the elapse of turn-on delay time $Ts$ necessary for the gate circuit in Figure 1 to switch into the voltage state and continues to rise for the duration of a rise time $T_1$ of the gate circuit to the left of the Josephson junction $J_3$. Then the pulse $I_{out}$ goes down for the duration of a rise time $T_2$ of the Josephson junction $J_3$. Therefore, the pulse width is determined as $(T_1+T_2)$. In consideration that the obtainable switching time of the Josephson junction is about 10 picoseconds, the pulse width of 20 picoseconds may be obtained by the above circuit.

The above pulse generator, if applied with appropriate design rule, will be able to operate correctly over wide operation range. For this purpose, the following design rule is proposed.

$$r_{11}=r_{12}=r_{21}=3/4\ r_0=1/8\ r_L$$

$$I_{11}=I_{12}=3/2\ I_2=I_3$$

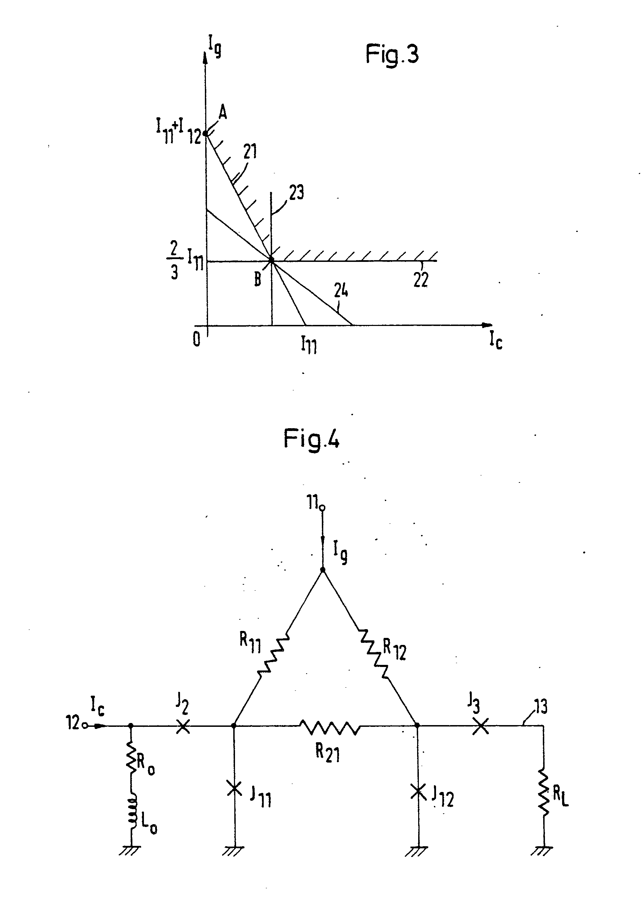

This design rule is based on the control characteristic of the above pulse generator as shown in Figure 3 which shows the control characteristic of the gate circuit (circuit on the left side of the Josephson junction $J_3$ of Figure 1) in the pulse generator with the shaded portion representing the voltage state of the gate circuit. The line 21 represents the threshold value characteristic for switching the Josephson junction $J_{11}$ into the voltage state; the line 23 for switching the Josephson junction $J_{12}$ into the voltage state with the Josephson junction $J_{11}$ in the zero-voltage state; the line 24 for switching the Josephson

junction $J_{12}$ after the completion of switching of the Josephson junction $J_{11}$; the line 22 for switching the Josephson junction $J_2$ after the completion of switching of the Josephson junctions $J_{11}$, $J_{12}$. Referring to Figure 3, in order to obtain a wide operation margin, it is appropriate to set the following conditions $I_{11}=I_{12}=3/2\ I_2$ for making the lines 21, 22, 23 intersect each other at a point; and $r_{11}=r_{12}=r_{21}=3/4\ r_0$ for placing the line 24 inside the shaded portion determined by the lines 21 and 22. Further, in order to prevent the input current $I_c$ from backlashing and make the input current $I_c$ flow through the resistor $R_0$ into ground even when the Josephson junction $J_2$ is switched into the voltage state, the condition $r_0 \gg r_L$ must be satisfied. $3/4\ r_0=1/8\ r_L$ is chosen for example.

The above-mentioned design adequacy will be explained in the following. The currents $i_{11}(=I_{g1})$ and $i_{12}(=I_{g2})$ flowing through the resistors $R_{11}$ and $R_{12}$ into the Josephson junctions $J_{11}$ and $J_{12}$ are given by

$$i_{11}=\frac{r_{12}}{r_{11}+r_{12}}I_g \qquad (1)$$

$$i_{12}=\frac{r_{11}}{r_{11}+r_{12}}I_g \qquad (2)$$

The input current $I_c$ is injected into the Josephson junction $J_{11}$ through the Josephson junction $J_2$. Thus, the condition for switching the Josephson junction $J_{11}$ is given by

$$\frac{r_{12}}{r_{11}+r_{12}}I_g+I_c>I_{11} \qquad (3)$$

The line 21 of Figure 3 corresponds to the above equation (3).

Since the allowable maximum gate current is $(I_{11}+I_{12})$ under the zero-voltage state condition of the Josephson junctions $J_{11}$ and $J_{12}$, the value of the intersection A of the ordinate and the line 21 of Figure 3 is $(I_{11}+I_{12})$. The condition for switching the Josephson junction $J_2$ is given by

$$I_c>I_2 \qquad (4)$$

The equation (4) corresponds to the line 23.

Considering the switching order $(J_{11}$, then $J_2)$ the gate current must be greater than the value of the intersection B of the lines 21 and 23. The gate current $I_g^{min}$ at the intersection B is expressed as

$$I_g^{min}=\frac{r_{11}+r_{12}}{r_{12}}(I_{11}-I_2) \qquad (5)$$

Apparently from equation (3), the input sensitivity of the gate is given by

$$\frac{r_{11}+r_{12}}{r_{12}}.$$

If we suppose $r_{11}=r_{12}\equiv r$ and $I_{11}=I_{12}\equiv I_0$ (the manufacture will be facilitated if the same resistance and the same critical current values are atoped), then an appropriate input sensitivity resistive to the noise $(r_{11}+r_{12})/r_{12}=2$ is obtained.

The following condition is required to switch the Josephson junction $J_{12}$ after the completion of switching the Josephson junction $J_{11}$:

$$i_{11}+i_{12}=I_g \qquad (6)$$

$$i_{11}\cdot r+i_{21}\cdot r_{21}=i_{12}\cdot r \qquad (7)$$

$$I_c+i_{11}=i_{21}+i_0 \qquad (8)$$

$$i_0\cdot r_0=i_{21}\cdot r_{21} \qquad (9)$$

where $i_{11}$, $i_{12}$, $i_{21}$ are currents flowing through the resistors $R_{11}$, $R_{12}$ and $R_{21}$ respectively; $i_0$ is a current flowing through the resistor $R_0$. From these equations we obtain the following equation for the line 24.

$$\frac{(2r_0\cdot r+r_0\cdot r_{21}+r\cdot r_{21})I_g+r_0(2r+r_{21})I_c}{2(r_{21}+r_0)r+r_{21}\cdot r_0}>I_0 \qquad (10)$$

After the Josephson junction $J_{12}$ has switched, the gate current is injected into the Josephson junction $J_2$. Assuming $r_0\ll r_L$, the condition for switching the Josephson junction $J_2$ is given by

$$I_g>I_2 \qquad (11)$$

The above equation (11) corresponds to the line 22. When the minimum value of $I_g$ given by the equation (11) agrees with $I_g^{min}$ of equation (5), the operation margin becomes maximum. Consequently, we obtain

$$I_2=\frac{2}{3}I_0$$

The values of the intersection points between the line 24 and ordinate and abscissa becomes small as the resistance $r_0$ increases. This is preferable in the light of operation margin, but, considering the backlash of the input current $I_c$, it is desirable to limit $r_0$ to a small value. Thus, the minimum allowable value of $r_0$ is the value attained at a contact point between the intersection B and the line 24.

As a result obtained are $I_g=2/3\ I_0$ and $I_c=2/3\ I_0$. Substituting them into equation (8) under the condition $r_{21}=r_{11}\equiv r$ for the convenience of manufacture, we obtain

$$\frac{3(r_0+r)\dfrac{2}{3}+3r_0\cdot\dfrac{2}{3}}{2(r_0+r)+r_0}>1 \qquad (12)$$

Hence $r_0=4/3\ r$ is introduced.

More concretely, when the circuit parameters are chosen as follows

$$r_{11}=r_{12}=r_{21}=3/4 \quad r_0=1/8 \quad r_L=0.5\ \Omega$$

$$I_{11}=I_{12}=3/2 \quad I_2=I_3=300\ \mu A,$$

the pulse width calculated by the computer simulation is approximately 30 picoseconds, which is sufficiently short so that the Josephson circuit and the memory circuit can be operated with very high operation speed. The above circuit parameters can easily be achieved by ordinary Josephson integrated circuit manufacturing technique employing lithography with minimum line width of 5 micrometer.

Compared with the pulse generator using a conventional interferometer type gate circuit, the pulse generator according to this invention needs no input line for magnetic coupling with the gate circuit, which in turn reduces the number of integrated circuit fabrication processes. Further, the absence of inductances makes it possible to produce the logic gate in small and is suited for high density integration. It also does not require an additional provision to dampen the resonance because there is no inductance components causing the resonance in this circuit. Moreover, since this circuit does not use a superconductive loop, there is no risk of trapping stray magnetic flux and causing erroneous operation.

Now, another embodiment is explained in the following which is based on the construction of Figure 1 but capable of further reducing the pulse rise time and the pulse fall time. Figure 4 shows the circuit of this embodiment. The difference from the first embodiment of Figure 1 is that an inductance component $L_0$ is connected in series with the resistor $R_0$ connected to the input terminal. The operation of this circuit is detailed below.

As the input current $I_c$ is supplied from the input terminal 12, $I_c$ flows through the Josephson junction $J_2$ into the Josephson junction $J_{11}$. This causes the current flowing through the Josephson junction $J_{11}$ to inject into the Josephson junction $J_{12}$ through the resistor $R_{21}$ and the resistors $R_{11}$, $R_{12}$, switching the Josephson junction $J_{12}$ into the voltage state. On the other hand, the gate current $I_g$ is bisected into two current paths, a first path made up of the Josephson junction $J_2$, the resistor $R_0$ and the inductance $L_0$ and a second path made up of the Josephson junction $J_3$, the output line 13 and the load resistor $R_L$. If the inductance $L_0$ is set sufficiently large, the current path consisting of the Josephson junction $J_2$, resistor $R_0$ and inductance $L_0$ presents dynamically a large impedance, causing the gate current $I_g$ to flow through the Josephson junction $J_3$ into the output line 13. As a result, the current in the output line 13 rises during the switching time of the Josephson junction $J_{12}$. When the current flowing through the output line 13 exceeds the critical current value of the Josephson junction $J_3$, the

Josephson junction $J_3$ is switched into the voltage state interrupting the output current. Therefore, a pulse current is obtained through the output line 13. The gate current $I_g$ flows through the Josephson junction $J_2$, resistor $R_0$ and inductance $L_0$ into ground, switching the Josephson junction $J_2$ into the voltage state. Consequently, the gate current $I_g$ is distributed according to the resistances of the junctions $J_{11}$, $J_{12}$, $J_2$, $J_3$ in the voltage state and flows into ground through them. The input current $I_c$, on the other hand, flows through the resistor $R_0$ and inductance $L_0$ into ground. In this way, the input and output currents are separated.

As explained in the foregoing, the switching order of the Josephson junctions in this circuit is $J_{11}$, $J_{12}$, $J_3$ and $J_2$, and the output pulse $I_{out}$ rises after completion of switching of the Josephson junctions $J_{11}$ and $J_{12}$. Thus an overall capacity of the circuit to be charged at that moment is the sum (=2C) of the capacity (C) of Josephson junctions $J_{11}$ and $J_{12}$. However, in the circuit of Figure 1 the sequence of switching is $J_{11}$, $J_{12}$, $J_2$ and $J_3$. Therefore, when $I_{out}$ rises, the capacitances of the Josephson junctions $J_{11}$, $J_{12}$ and $J_2$ (each capacity is supposed to be C) which amounts to 3C, 1.5 times the capacity of the circuit shown in Figure 4, have to be charged. Now the rise time and fall time of the output pulse $I_{out}$ depend on the time constant CR. Since the capacitance of the circuit of Figure 4 when $I_{out}$ is produced is 2/3 the capacitance of the circuit of Figure 1, as mentioned above, the pulse obtained with the pulse generator of Figure 4 has shorter rise time and fall time. In this circuit, too, in order to keep the high input sensitivity and wide operation margin, it is preferable that the design rule similar to that of Figure 1 be followed. It is apparent that when the connecting sequence of the resistor $R_0$ and inductance $L_0$ is reversed the same effect can be obtained.

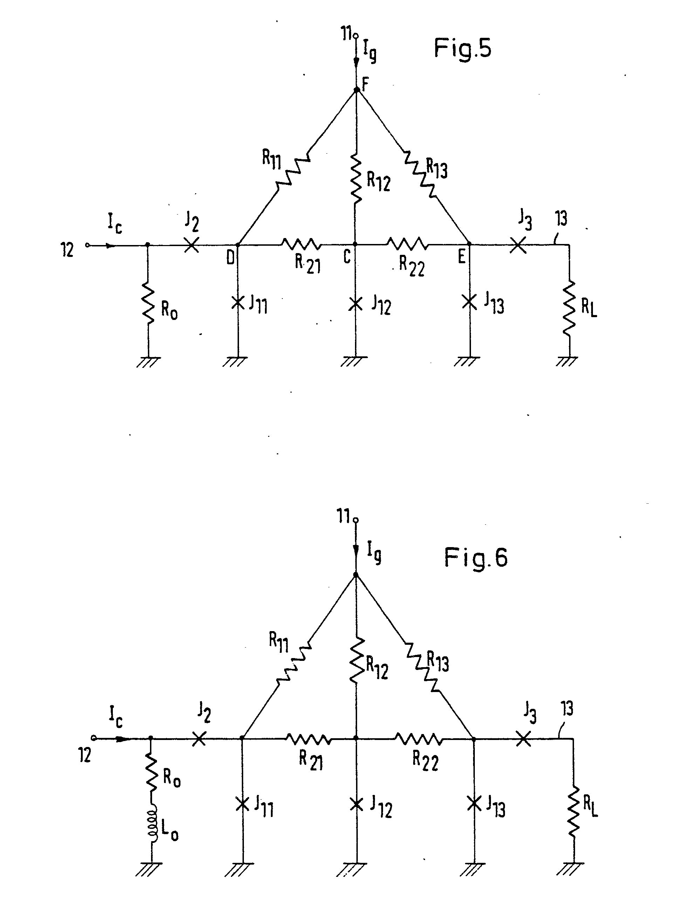

Figure 5 shows a pulse generator circuit, a still another embodiment of this invention, in which further improvement is made on the operation margin and gain. In this circuit, a resistor $R_{22}$ (resistance $r_{22}$) is inserted between the connecting point C or D (between resistors $R_{12}$ and $R_{21}$ or between resistors $R_{11}$ and $R_{21}$) and the Josephson junction $J_3$ or $J_2$; a resistor $R_{13}$ (resistance $r_{13}$) is inserted between the connecting point E (between the resistor $R_{22}$ and the junction $J_3$) and the connecting point F (between resistors $R_{11}$ and $R_{12}$); and a Josephson junction $J_{13}$ (critical current $I_{13}$) is added between the connecting point E and the ground. The operation margin and the gain are further improved as the number of resistors and Josephson junctions increases. This may be explained as follows.

As is evident from the explanation for Figure 3, the input sensitivity depends on the gradient of the threshold line 21 for the Josephson junction $J_{11}$. If we suppose the added resistors (n pieces including $R_{11}$ and $R_{12}$) have resistance equal to that of $R_{11}$ and $R_{12}$ and the Josephson junctions (n pieces including $J_{11}$ and $J_{12}$) have critical current equal to $I_{11}$ of $J_{11}$ and $I_{12}$ of $J_{12}$, then the threshold line for the line 21 is expressed as

$$\frac{I_g}{n}+I_c=I_{11} \qquad (13)$$

Therefore, the greater the number of added resistors and Josephson junctions, the higher the input sensitivity will be.

Since it holds that $I_g>I_2$ and $I_c>I_2$ for lines 22 and 23, respectively, the intersection between lines 21, 22 and 23 is given by

$$\frac{I_2}{n}+I_2=I_{11} \qquad (14)$$

That is

$$I_2=\frac{n}{n+1}\cdot I_{11}$$

On the other hand, since

$$I_g^{min}=I_2=\frac{n}{n+1}\cdot I_{11} \qquad (15)$$

$$I_g^{max}=n\cdot I_{11} \qquad (16)$$

Hence

$$\frac{I_g^{max}}{I_g^{min}}=n+1 \qquad (17)$$

Equation (17) also shows that the operation margin increases as the number of added resistors and Josephson junctions increases.

The operation of the circuit as shown in Figure 5 is explained in the following. The gate current $I_g$ is trisected into three current paths, a first path consisting of resistor $R_{11}$ and Josephson junction $J_{11}$, a second path consisting of resistor $R_{12}$ and Josephson junction $J_{12}$, and a third path consisting of resistor $R_{13}$ and Josephson junction $J_{13}$ with $I_{g1}$, $I_{g2}$ and $I_{g3}$, respectively.

As the input current $I_c$ is injected, it flows through the Josephson junctions $J_2$ and $J_{11}$ into ground. As a result, both the gate current $I_{g1}$ and the input current $I_c$ flow through the Josephson junction $J_{11}$, switching it into the voltage state. This causes the current flowing through the Josephson junction $J_{11}$ to inject through the resistor $R_{21}$ and the resistors $R_{11}$, $R_{12}$ into the Josephson junction $J_{12}$, switching the Josephson junction $J_{12}$ to the voltage state. Then the current flowing through the junction $J_{12}$ is injected into the Josephson junction $J_{13}$ through the resistor $R_{22}$ and the resistors $R_{12}$, $R_{13}$, thereby switching the Josephson junction $J_{13}$ into the voltage state.

Consequently, the gate current $I_g$ is bisected into two paths, a first path consisting of

Josephson junction $J_2$ and resistor $R_0$ and a second path consisting of Josephson junction $J_3$, output line 13 and load resistor $R_L$. If the resistance $r_L$ of the load resistor $R_L$ is set sufficiently higher than the resistance $r_0$ of the resistor $R_0$, most of the gate current $I_g$ flows through the Josephson junction $J_2$ and resistor $R_0$ thus switching the Josephson junction $J_2$ into the voltage state. This causes the input current $I_c$ to flow through the resistor $R_0$ into ground and the gate current $I_g$ to flow through the Josephson junction $J_3$, output line 13 and load resistor $R_L$ and into the ground. In this way, the input and output are separated.

As the current flowing through the output line 13 exceeds the critical current value $I_3$ of the Josephson junction $J_3$, the Josephson junction $J_3$ is switched into the voltage stage, cutting off the output current. As a result, a pulse current is obtained through the output line 13. The gate current $I_g$ is distributed according to the resistance of each junction in the voltage state and flows into ground through them.

As can be seen from the foregoing, the rise time and fall time of the output pulse current $I_{out}$ are given by the switching time of the Josephson junctions $J_2$ and $J_3$, respectively. The pulse width is also given as the sum of these switching times.

Figure 6 shows another embodiment of the present invention in which an inductance component $L_0$ is connected in series with the resistance $R_0$ of Figure 5 to further shorten the output pulse width. The operation of this circuit is similar to that of Figure 1 and Figure 4, so detailed explanation is not presented here. In summary, at the time of switching the Josephson junction $J_3$ from which the output pulse is obtained, the junction $J_2$ is not switched into the voltage state due to the inductance component $L_0$. Therefore the overall capacity of the gate circuit is the sum of each capacity of the Josephson junctions $J_{11}$, $J_{12}$ and $J_{13}$, which is 3/4 the capacity of the circuit of Figure 5. This means the pulse width is further reduced.

To ensure correct operation of the pulse generator shown in Figures 5 and 6 over wide operation range, it is desirable to follow the design rule, as explained for Figure 1, such as shown below.

$$r_{21}=r_{22}=0.4\ r_0$$

$$r_{11}=r_{12}=r_{13}$$

$$r_L=10\ r_0$$

$$I_{11}=I_{12}=I_{13}$$

$$I_2=0.7\ I_{11}.$$

**Claims**

1. A circuit utilizing Josephson junctions of the type having first and second ends and having an extremely low impedance between said first and second ends in a zero voltage state and a high impedance between said first and second ends in a voltage state and changing from said zero voltage state to said voltage state in response to a current flowing between said first and second ends which is greater than a respective critical current, comprising a first group of "N" ($N \geqq 2$) resistors ($R_{11}$, $R_{12}$, $R_{13}$) connected together at one end (B, F) thereof and each having a predetermined resistance, a second group of "N−1" resistors ($R_{21}$, $R_{22}$) each being connected between the other ends of two of said "N"-resistors and having a predetermined resistance, said second group of resistors being connected in series between a first node (D) and a second node (A, E), a first group of "N" Josephson junctions ($J_{11}$, $J_{12}$, $J_{13}$) connected between a reference potential and respective ones of said other ends (A, D, C, E) of said first group of resistors ($R_{11}$, $R_{12}$, $R_{13}$) and each having a predetermined critical current characterized by further comprising a first Josephson junction ($J_2$) connected at one end thereof with said first node and having a predetermined critical current, a first resistor ($R_0$) connected between said reference potential and the other end of said first Josephson junction ($J_2$) and having a predetermined resistance, a second Josephson junction ($J_3$) connected at one end thereof with said second node and having a predetermined critical current, and a second resistor ($R_L$) connected with the other end of said second Josephson junction ($J_3$) and having a predetermined resistance.

2. A circuit as claimed in claim 1, characterized in that it further comprises an input terminal (12) connected with the node between said first Josephson junction ($J_2$) and said first resistor ($R_0$) and supplied with an input current ($I_c$) having a predetermined amplitude, and a gate terminal (11) connected with said one end of said first group of resistors and supplied with a gate current ($I_g$) having a predetermined amplitude, said circuit producing an output pulse from said second resistor ($R_L$) when said input current is applied to said input terminals.

3. A circuit as claimed in claim 1, characterized in that an inductance component ($L_0$) is connected in series with said first resistor and having a predetermined inductance value.

4. A circuit as claimed in claim 1, characterized in that "N" is 2.

5. A circuit as claimed in claim 1, characterized in that "N" is 3.

6. A circuit as claimed in claim 4, characterized in that said circuit satisfies the conditions:

$$r_{11}=r_{12}=r_{21}=3/4\ r_0=1/8\ r_L$$

$$I_{11}=I_{12}=3/2\ I_2=I_3$$

where $r_{11}$ and $r_{12}$ are the resistances of said first group of resistors counting from said first node side, $r_{21}$ is the resistance of said second group of resistors, $I_{11}$ and $I_{12}$ are the critical current values of said first group of Josephson junctions counting from first node side, $I_2$ and $I_3$ are the critical currents of said first and second Josephson junctions ($J_2$, $J_3$), $r_0$ is the resistance of said first resistor ($R_0$), and $r_L$ is the resistance of said second resistor.

7. A circuit as claimed in claim 5, characterized in that the said circuit satisfies the conditions:

$$r_{12}=r_{22}=0.4 \ r_0$$

$$r_{11}=r_{12}=r_{13}$$

$$r_L=10 \ r_0$$

$$I_{11}=I_{12}=I_{13}$$

$$I_2=0.7 \ I_{11}$$

where $r_{11}$, $r_{12}$, $r_{13}$ and $r_{21}$, $r_{22}$ are the resistances of said first and second groups of resistors, respectively, counting from said first node side, $I_{11}$, $I_{12}$ and $I_{13}$ are the critical currents of said first group of Josephson junctions counting from said first node side, $I_2$ is the critical current of said first Josephson junctions, $r_0$ is the resistance of said first resistor ($R_0$), and $r_L$ is the resistance of said second resistor ($R_L$).

**Patentansprüche**

1. Schaltung mit Anwendung von Josephson-Übergängen des Typs mit einem ersten und einem zweiten Ende mit einer extrem niedrigen Impedanz zwischen dem ersten und dem zweiten Ende im Nullspannungszustand, einer hohen Impedanz zwischen dem ersten und dem zweiten Ende in einem Spannungszustand und einem Wechsel vom Nullspannungszustand in den Spannungszustand, in Abhängigkeit von einem Strom, der zwischen dem ersten und dem zweiten Ende fließt und der größer ist als ein entsprechender kritischer Strom, mit einer ersten Gruppe aus "N" (N≧2) Widerständen ($R_{11}$, $R_{12}$, $R_{13}$), die miteinander an einem Ende (B, F) verbunden sind und jeder einen vorbestimmten Widerstandswert hat, einer zweiten Gruppe von "N−1" Widerständen ($R_{21}$, $R_{22}$), von denen jeder zwischen den anderen Enden von je zwei der "N"-Widerständen angeschlossen ist und einen vorbestimmten Widerstandswert hat, wobei die zweite Gruppe von Widerständen in Serie angeschlossen ist zwischen einem ersten Knoten (D) und einem zweiten Knoten (A, E), und einer ersten Gruppe von "N" Josephson-Übergängen ($J_{11}$, $J_{12}$, $J_{13}$), die zwischen eine dem Bezugspotential und den entsprechenden anderen Enden (A, D, C, E) der ersten Gruppe von Widerständen ($R_{11}$, $R_{12}$, $R_{13}$) angeschlossen sind und je einen vorbestimmten kritischen Strom haben, dadurch gekennzeichnet, daß die Schaltung ferner aufweist einen ersten Josephson-Übergang ($J_2$), der mit einem Ende mit dem ersten Knoten verbunden ist und einen vorbestimmten kritischen Strom aufweist, einen ersten Widerstand ($R_0$), der zwischen dem Bezugspotential und dem anderen Ende des ersten Josephson-Übergangs ($J_2$) angeschlossen ist und einen vorbestimmten Widerstandswert aufweist, einen zweiten Josephson-Übergang ($J_3$), der mit einem Ende mit dem zweiten Knoten verbunden ist und einen vorbestimmten kritischen Strom hat, und einen zweiten Widerstand ($R_L$), der mit dem anderen Ende des zweiten Josephson-Übergangs ($J_3$) verbunden ist und einen vorbestimmten Widerstandswert hat.

2. Schaltung nach Anspruch 1, dadurch gekennzeichnet, daß sie ferner aufweist eine Eingangsklemme (12), die mit dem Knoten zwischen dem ersten Josephson-Übergang ($J_2$) und dem ersten Widerstand ($R_0$) verbunden ist und versorgt wird mit einem Eingabestrom ($I_c$) mit einer vorbestimmten Amplitude, und eine Gate-Klemme (11), die mit einem Ende der ersten Gruppe von Widerständen verbunden ist und mit einem Gate-Strom ($I_G$) mit einer vorbestimmten Amplitude versorgt wird, wobei die Schaltung einen Ausgangspuls an dem zweiten Widerstand ($R_L$) erzeugt, wenn der Eingabestrom auf die Eingabeklemmen gegeben wird.

3. Schaltung nach Anspruch 1, dadurch gekennzeichnet, daß eine Induktionskomponente ($L_0$) mit einem vorbestimmten Induktionswert in Serie geschaltet wird mit dem ersten Widerstand.

4. Schaltung nach Anspruch 1, dadurch gekennzeichnet, daß "N" 2 ist.

5. Schaltung nach Anspruch 1, dadurch gekennzeichnet, daß "N" 3 ist.

6. Schaltung nach Anspruch 4, dadurch gekennzeichnet, daß die Schaltung die folgenden Bedingungen erfüllt:

$$r_{11}=r_{12}=r_{21}=3/4 \ r_0=1/8 \ r_L$$

$$I_{11}=I_{12}=3/2 \ I_2=I_3,$$

Wobei $r_{11}$ und $r_{12}$ die Widerstandswerte der ersten Gruppe von Widerständen, gezählt von der ersten Knotenseite sind, $r_{11}$ der Widerstandswert der zweiten Gruppe von Widerständen ist, $I_{11}$ und $I_{12}$ die kritischen Stromwerte der ersten Gruppe von Josephson-Übergängen, gezählt von der ersten Knotenseite sind, $I_2$ und $I_3$ die kritischen Ströme des ersten und des zweiten Josephson-Übergangs ($J_2$, $J_3$) sind, $r_0$ der Widerstandswert des ersten Widerstandes ($R_0$) ist und $r_L$ der Widerstandswert des zweiten Widerstandes ($R_L$) ist.

7. Schaltung nach Anspruch 5, dadurch gekennzeichnet, daß sie die folgenden Bedingungen erfüllt:

$$r_{12}=r_{22}=0,4 \ r_0$$

$$r_{11}=r_{12}=r_{13}$$

$$r_L=10 \ r_0$$

$$I_{11}=I_{12}=I_{13}$$

$$I_2=0,7 \ I_{11}$$

wobei $r_{11}$, $r_{12}$, $r_{13}$ bzw. $r_{21}$, $r_{22}$ die Widerstandswerte der ersten bzw. zweiten Gruppe von Widerständen, gezählt von der ersten Knotenseite sind, $I_{11}$, $I_{12}$ und $I_{13}$ die von der ersten Knotenseite gezählten, kritischen Ströme der ersten Gruppe von Josephson-Übergängen sind, $I_2$ der kritische Strom des ersten Josephson-Übergangs ist, $r_0$ der Widerstandswert des ersten Widerstandes ($R_0$) ist und $r_L$ der Widerstandswert des zweiten Widerstandes ($R_L$) ist.

## Revendications

1. Circuit utilisant des jonctions Josephson du type ayant une première et une seconde extrémité et ayant une impédance extrêmement entre lesdites première et seconde extrémités dans un état de tension nulle et une impédance élevée entre lesdites première et seconde extrémités dans un état de tension, et passant dudit état de tension nulle audit état de tension en réponse à un courant circulant entre lesdites première et seconde extrémités, qui est supérieur à un courant critique respectif, comprenant un premier groupe de "N" ($N \geq 2$) résistances ($R_{11}$, $R_{12}$, $R_{13}$) connectées les unes aux autres à l'une de leurs extrémités (BF) et ayant chacune une résistance prédéterminée, un second groupe de "N−1" résistances ($R_{21}$, $R_{22}$) étant chacune connectée entre les autres extrémités de deux desdites "N" résistances et ayant une résistance prédéterminée, ledit second groupe de résistances étant connecté en série entre un premier noeud (D) et un second noeud (A, E), un premier groupe de "N" jonctions Josephson ($J_{11}$, $J_{12}$, $J_{13}$) connectées entre un potentiel de référence et des extrémités respectives parmi les autres extrémités (A, D, C, E) dudit premier groupe de résistances ($R_{11}$, $R_{12}$, $R_{13}$) et ayant chacune un courant critique prédéterminé, caractérisé en ce qu'il comprend en outre une première jonction Josephson ($J_2$) dont l'une des extrémités est connectée audit premier noeud et ayant un courant critique prédéterminé, une première résistance ($R_0$) connectée entre ledit potentiel de référence et l'autre extrémité de ladite première jonction Josephson ($J_2$) et ayant une résistance prédéterminée, une seconde jonction Josephson ($J_3$) dont l'une dex extrémités est connectée audit second noeud et ayant un courant critique prédéterminé, et une seconde résistance ($R_L$) connectée à l'autre extrémité de ladite seconde jonction Josephson ($J_3$) et ayant une résistance prédéterminée.

2. Circuit selon la revendication 1, caractérisé en ce qu'il comprend en outre une borne d'entrée (12) connectée au noeud situé entre ladite première jonction Josephson ($J_2$) et ladite première résistance ($R_0$) et alimentée avec un courant d'entrée ($I_c$) ayant une amplitude prédéterminée, et une borne de gâchette (11) connectée à ladite extrémité dudit premier groupe de résistances et recevant un courant de gâchette ($I_g$) ayant une amplitude prédéterminée, ledit circuit produisant une implusion de sortie provenant de ladite seconde résistance ($R_L$) lorsque ledit courant d'entrée est fourni auxdites bornes d'entrée.

3. Circuit selon la revendication 1, caractérisé en ce qu'un composant d'inductance ($L_0$) est connecté en série à ladite première résistance et en ce qu'il présente une valeur d'inductance prédéterminée.

4. Circuit selon la revendication 1, caractérisé en ce que "N" est égal à 2.

5. Circuit selon la revendication 1, caractérisé en ce que "N" est égal à 3.

6. Circuit selon la revendication 4, caractérisé en ce que ledit circuit satisfait aux conditions suivantes:

$$r_{11} = r_{12} = r_{21} = 3/4 \quad r_0 = 1/8 \ r_L$$

$$I_{11} = I_{12} = 3/2 \quad I_2 = I_3$$

où $r_{11}$ et $r_{12}$ sont les résistances dudit premier groupe de résistances comptées à partir dudit côté du premier noeud, $R_{21}$ est la résistance dudit second groupe de résistances, $I_{11}$ et $I_{12}$ sont les valeurs des courants critiques dudit premier groupe de jonctions Josephson comptées à partir du premier noeud, $I_2$ et $I_3$ sont les courants critiques desdites première et seconde jonctions Josephson ($J_2$, $J_3$), $r_0$ est la valeur de ladite première résistance ($R_0$), et $r_L$ est la valeur de ladite seconde résistance.

7. Circuit selon la revendication 5, caractérisé en ce que ledit circuit satisfait aux conditions:

$$r_{12} = r_{22} = 0,4 \ r_0$$

$$r_{11} = r_{12} = r_{13}$$

$$r_L = 10 \ r_0$$

$$I_{11} = I_{12} = I_{13}$$

$$I_2 = 0,7 \ I_{11}$$

où $r_{11}$, $r_{12}$, $r_{13}$, et $r_{21}$, $r_{22}$ dont les résistances desdits premier et seconde groupes de résistances, respectivement, comptées à partir dudit premier noeud, $I_{11}$, $I_{12}$, $I_{13}$, sont les courants critiques dudit premier groupe de jonctions Josephson comptées à partir dudit premier noeyd, $I_2$ est le courant critique desdites premières jonctions Josephson $r_0$ est la valeur de ladite première résistance ($R_0$), et $r_L$ est la valeur de ladite seconde résistance ($R_L$).

Fig.1

Fig.2

1

Fig.3

Fig.4

Fig.5

Fig.6